# EUROPÄISCHE PATENTSCHRIFT

(11) **EP 2 418 925 B1**
(45) Veröffentlichungstag und Bekanntmachung des Hinweises auf die Patenterteilung: **05.03.2014**
(21) Anmeldenummer: 11169165.5
(22) Anmeldetag: 08.06.2011
(51) Int. Cl.: H05K 3/34, H05K 3/36

(54) **Flexfolienkontaktierung**
Flex film contacting
Mise en contact de feuilles flexibles

(30) Priorität: 11.08.2010 DE 102010039189
(43) Veröffentlichungstag der Anmeldung: 15.02.2012
(73) Patentinhaber: Robert Bosch GmbH, 70442 Stuttgart (DE)
(72) Erfinder: Liskow, Uwe, 71679 Asperg (DE)

(56) Entgegenhaltungen:
- FR-A1- 2 860 945
- JP-A- 2008 084 952
- US-A1- 2001 015 347

## Beschreibung

### Stand der Technik

DE 10 2005 002 813 B4 bezieht sich auf ein Steuermodul. Bei diesem Steuermodul handelt es sich um ein Steuermodul für ein Kraftfahrzeuggetriebe. Das Steuermodul umfasst einen ersten Gehäuseteil auf dem ein elektronisches Schaltungsteil angeordnet ist sowie ein zweites Gehäuseteil. Es ist ein Träger vorgesehen, an dem eine flexible Leiterfolie angeordnet ist, die in einem zwischen dem ersten Gehäuseteil und dem zweiten Gehäuseteil befindlichen Gehäuseinnenraum mit dem Schaltungsteil und die außerhalb des Gehäuseinnenraumes mit an dem Träger festgelegten elektrischen Bauelementen elektrisch verbunden ist. Das zweite Gehäuseteil ist auf die flexible Leiterfolie aufgesetzt. Das Steuermodul ist stapelförmig aufgebaut, wobei der Träger mit einer ersten Seite auf einer mit dem Schaltungsteil versehenen Innenseite des ersten Gehäuseteiles aufliegend angeordnet ist, das Schaltungsteil in einer Aussparung des Trägers angeordnet ist und die flexible Leiterfolie auf der von dem ersten Gehäuseteil abgewandten zweiten Seite des Trägers angeordnet ist.

EP 1 396 885 A1 bezieht sich auf eine Steuereinheit für Kfz-Anwendungen. Ein elektronischer Schaltkreis umfasst elektronische Komponenten wie zum Beispiel einen Schaltungsträger. Ein Basiselement dient dazu, den Schaltungsträger zu kühlen, ferner sind Anschlussstifte vorgesehen, die dem externen Anschluss dienen und durch die insbesondere Signale vom Schaltungsträger nach außen übertragen werden. Ein Versieglungsharz umschließt den Schaltungsträger sowie den Schaltkreis und das Element, was zur Kühlung dient, wobei der Schaltungsträger auf ein Basiselement platziert wird, so dass der thermische Ausdehnungkoeffizient des Schaltungsträgers im wesentlichen dem des Basiselementes, das zur Kühlung dient, entspricht.

EP 1 932 404 B1 bezieht sich auf ein Steuergerät insbesondere für ein Kraftfahrzeuggetriebe. Das Steuergerät umfasst einen Träger auf dem ein elektronisches

Schaltungsteil aufgebracht ist und an dem wenigstens eine über elektrische Verbindungsmittel mit dem elektronischen Schaltungsteil verbundene flexible Leiterfolie angeordnet ist. Ein mit einer Innenausnehmung versehenes und das elektronische Schaltungsteil umgebendes Rahmenteil ist auf dem Träger derart angeordnet, dass das elektronische Schaltungsteil in der Innenausnehmung des Rahmenteils angeordnet ist und dass die mit dem elektronischen Schaltungsteil verbundenen elektrischen Verbindungsmittel durch wenigstens eine Aussparung des Rahmenteils hindurch mit der wenigstens einen flexiblen Leiterfolie elektrisch verbunden sind.

Derzeit werden Getriebesteuergeräte beispielsweise mit einem Metallgehäuse versehen und im allgemeinen im Ölsumpf eine Getriebes, insbesondere eines Kfz-Getriebes angeordnet. Die derzeit eingesetzten Getriebesteuergeräte umfassen eingeglaste Rund-Pins, die üblicherweise durch Laserschweißens mit dem Stanzgitteraufbau und der Verbindungstechnik kontaktiert werden. Vorentwicklungsprojekte für neue Generationen von Getriebesteuergeräten verlaufen dahingehend, dass diese Steuergeräte radial austretende Flachstecker aufweisen. Es ist vorgesehen, dass diese Flachstecker mit einer Flexfolie (FPC) stoffschlüssig verbunden werden, wozu sich beispielsweise Laserschweißen anbietet. Auf der dem Flachpin abgewandten Seite der Flexfolie sind Kupfer-Pads aufgelegt, über welche die elektrische Kontaktierung der Flexfolie sichergestellt werden soll.

Aus der FR 2 860 945 ist eine Verbindung eines flexiblen Flachleiters mit einem elektrischen Kontakt gemäß dem Oberbegriff von Anspruch 1 bekannt.

### Offenbarung der Erfindung

Erfindungsgemäß wird vorgeschlagen, ein Ende einer Flexfolie nach Art eines Steckers an eine Kontaktreihe des Steuergerätes, d. h. der transmission control unit (TCU) eines Sensors eines Aktuators zu schieben, dort mittels einer stoffschlüssigen Verbindung einerseits zu befestigen und anderseits zu kontaktieren. Zur Herstellung der stoffschlüssigen Verbindung kommen einerseits das Laserschweiß- und das Widerstandsschweißverfahren zum Einsatz, andererseits besteht auch die Möglichkeit, die stoffschlüssige Verbindung über eine Lötverbindung herzustellen. Insbesondere wird das steckerförmig ausgebildete Ende der Flexfolie unter Zugentlastung dargestellt Dies folgt dadurch, dass das zu kontaktierende Ende der Flexfolie enger ausgebildet ist als nötig und einen Wellenschlag in Form eines 180° Bogens aufweist. Des weiteren kann innerhalb desselben Bogens ein Stützkern oder dergleichen ausgebildet sein, um den die Flexfolie, die in der Regel ein Schichtaufbau aufweist, in einem 180° Bogen herumgeführt ist.

Die Kontaktierrichtung zwischen der Kontaktreihe TCU der Flexfolie und die Ebene der Flexfolie sind nicht identisch, sondern stehen in einem Winkel von beispielsweise 90° zueinander. Durch die erfindungsgemäß vorgeschlagene Lösung wird erreicht, dass einerseits der Materialeinsatz hinsichtlich der vorgefertigten Flexfolie verringert werden kann, des weiteren können Anbindungsstellen in Gestalt von Kupfer-Pads eingespart werden. Des weiteren zeichnet sich die erfindungsgemäß vorgeschlagenen Lösung durch eine volle Abdichtbarkeit aus. Darüber hinaus ist hervorzuheben, dass bei Einführen des Flexfolienendes in einen der Kontaktreihe der TCU zugeordneten Gehäuseschlitzes, eine Selbstzentrierung der Flexfolie innerhalb des Gehäuses vor Herstellen der stoffschlüssigen Verbindung erreicht werden kann. Dies verbessert die Prozesssicherheit bei automatisierter Herstellung der stoffschlüssigen Verbindung im Wege des Lötverfahrens des Laserschweißverfahrens oder des Widerstandsschweißverfahrens ganz erheblich.

Bei Steuergerätegehäusen, die elektronische Bauelemente, beispielsweise für eine TCU oder einen Sensor oder dergleichen aufnehmen, kann es sich um gebaute Gehäuse handeln; Steuergerätegehäuse können aber heute auch durch Moldmasse dargestellt werden, wobei diese das Gerätegehäuse darstellende Moldmassen allgemein im Wege des Transfermoldens hergestellt werden. Üblicherweise werden Kontakte oder Kontaktreihen durch Kontaktreihen, Kontaktstifte oder Kontaktbleche dargestellt, die im allgemeinen über eine Vorumspritzung vorstehend vorkonfektioniert sind und relativ zueinander positioniert innerhalb eines Elektronikgehäuses angeordnet sind. Bei diesen elektrischen Kontakten von Steuergerätegehäusen ist in der Regel ein Ende eines jeden elektrischen Kontaktes mit einem Schaltungsträger oder einem anderen Bauteil elektrisch leitend verbunden. Die elektrisch leitenden Verbindungen werden in der Regel über Bonden unter Einsatz von Leitkleber durch Löten oder durch Hartlöten oder durch andere stoffschlüssige Verbindungstechniken wie zum Beispiel das Schweißen hergestellt.

Der innerhalb des Gerätegehäuses, sei es ein gemoldetes, sei es ein gebautes Gehäuse aufgenommener Schaltungsträger mit daran befestigten Kontakten wird nunmehr in ein dichtes Gehäuse überführt, wobei es sich zum Beispiel beim Molden um eine Duroplastumspritzung handeln kann, die bevorzugt im Wege des Transfermoldes hergestellt werden kann. Die Duroplastumspritzung umgibt den Schaltungsträger mit den darin aufgenommen elektronischen Bauelementen, bildet mit einer Kontaktblechrelhe im allgemeinen einen Block und stellt gleichzeitig einen blockförmigen Bund und eine Abdichtung des Schaltungsträgers samt der aufgenommenen elektronischen Bauelemente gegen die Umgebung dar.

Das andere Ende der elektrischen Kontakte beziehungsweise der elektrischen Kontaktreihe, welches aus dem durch die Moldmasse gebildeten Gehäuse hervorsteht, oder aus einem gebauten Gehäuse herausragt, stellt einen stiftförmigen elektrischen Kontakt dar.

Dieser elektrische Kontakt, oder diese elektrischen Kontakte, die seitlich aus dem Moldgehäuse oder einem gebauten Gehäuse herausstehen, werden erfindungsgemäß durch eine einseitig offene Flexfolie (FPC) kontaktiert, die von einer normalen flachebenen Gestalt einen Winkel von beispielsweise 180° oder auch zwischen Winkeln von etwas größer als 0° bis zu 180°, oder aufgerollt bis zu 360° gefaltet, oder gerollt sein kann, derart, dass der offene Bereich der Deckfolie, welcher die Leiterbahnschicht der Flexfolie überdeckt, zugänglich ist. Dabei ist die an dieser Stelle freiliegende Leiterbahn elektrisch kontaktierbar. Der Bereich der Deckfolie, welcher eine Öffnung aufweist oder ganz vom offenen Ende der Flexfolie entfernt ist, kann auf eine bestimmte Länge an der Flexfolie komplett entfallen; alternativ besteht die Möglichkeit nur einen Streifen über die gesamte Breite der Flexfolie frei zu legen, oder einzelne Bereiche oberhalb der die Leiterbahn bildenden Schicht der Flexfolie freizulegen. Die Breite dieser einzelnen Bereiche bzw. Öffnungen kann kleiner gleich, oder größer gleich als die jeweilige Leiterbahnbreite gewählt werden. Abhängig von der Festigkeit der Leiterbahnen beziehungsweise der die Leiterbahnen darstellenden Schicht im Schichtaufbau der Flexfolie kann diese einfach bogenförmig umgelegt, gefaltet, oder scharf geknickt werden. Um die mechanische Belastung der die elektrischen Leitungen darstellenden Leiterbahnen im Schichtaufbau der Flexfolie gering zu halten und insbesondere an der Umlenkstelle klein zu halten, lässt sich der Schichtaufbau der Flexfolie durch einen Stützkörper unterstützen, um den die Flexfolie gebogen oder gefaltet ist. Dieser Stützkörper kann zum Beispiel im Bereich der Falzstelle bzw. der Umlenkstelle ein halbkreisrundes Profil ähnlich wie ein Tragflügel in Tropfenform aufweisen. Durch diesen Stützkörper wird die Flexfolie In Form gehalten und insbesondere bei der Herstellung der elektrischen Kontaktierung abgestützt, so dass eine stoffschlüssige Verbindung zwischen den Kontakten bzw. den Einzelkontakten einer Kontaktreihe eines gemoldeten oder gebauten Steuergerätegehäuses hergestellt werden kann.

Ein derart vorkonfektioniertes offenes Ende einer Flexfolie wird nun in einen Kontaktschlitz am Elektronikgehäuse eingesteckt und bis zum Anschlagen an einen Anschlag eingesteckt.

Über die seitlichen Ränder ist die Flexfolie bzw. deren offenes mit einem Wellenschlag, einem 180° Bogen, oder dergleichen deformiertes Ende seitlich geführt. Im Moldgehäuse, oder im gebauten Gehäuse sind im Bereich des Kontaktschlitzes zum Einführen des offenen Endes der Flexfolie Öffnungen eingebracht. Diese Öffnungen können sich an der Oberseite, oder an der Unterseite, oder an Unter- und Oberseite des Moldgehäuses bzw. des gebauten Gehäuses befinden. Durch diese Gehäuseöffnungen ist die Berührstelle des offenen Endabschnittes der Flexfolie mit freigelegten Leiterbahnen zugänglich Durch diese Berühröffnungen, seien sie an der Unterseite, seien sie an der Oberseite oder seien sie an der Unter- und Oberselte des Gehäuses im Bereich des Kontaktschlitzes ausgebildet, kann ein Wärmeeintrag erfolgen, so dass eine stoffschlüssige Verbindung zwischen den in die Berührstelle hineinragenden elektrischen Kontakten des Haltungsträgers und den freigelegten Leiterbahnen der entsprechenden Leiterbahnschicht der Flexfolie erfolgen kann. So kann zum Beispiel ein Wärmeeintrag durch Einkopplung eines Lasereinstrahles erfolgen, der sowohl den elektrischen Kontakt als auch die Leiterbahn im Bereich der Berührstelle aufschmilzt und eine stoffschlüssige Verbindung herstellt. In einer vorteilhaften Ausführungsvariante besteht auch die Möglichkeit, die frei gelegten Leiterbahnen vorher vorzuverzinnen, so dass ein Wärmeeintrag an der Berührungsstelle die beiden Partner, d. h. die frei gelegten Leiterbahnen mit diese berührenden elektrischen Kontakte des Steuergerätes zum Beispiel verlötet. Anstelle eines bogenförmig umgelenkten, hinsichtlich der Leiterbahn freigelegten Endes des offenen Abschnittes der Flexfolie kann auch ein Kabel, ein Flachbahnenkabel, eingesetzt werden. Die Kontakte, die in den Kontaktschlitz seitlich oder nach oben oder unten orientiert in einen Kontaktbereich am gemoldeten oder gebauten Steuergehäuse hervorstehen, können als flache Blechstreifen oder Runddrähte ausgebildet sein, sind in der Regel elektrisch leitend und lassen sich zur Herstellung einer stoffschlüssigen Verbindung verwenden, sind daher verschweiß- oder verlötbar, oder können unter Einsatz eines Leitklebers miteinander verklebt werden.

Die Kontaktstelle, d. h. die Berührstelle zwischen den elektrischen Kontakten, sei es ein Einzelkontakt, seien es die Kontakte einer Kontaktreihe, kann an einer beliebigen Stelle in Bezug auf die freigelegten Leiterbahnen liegen, je nach Erfordemis zum Beispiel, um eine leichtere Zugänglichkeit für einen Wärmeeintrag über einen Laserstrahl zu schaffen, diesen besser einzukoppeln und/oder um Toleranzen bei den Bauteilen besser ausgleichen zu können. Der Einsatz eines Stützkörpers zum Abstützen der rückwärtigen Seite eines beispielsweise einen Bogen aufweisenden, offenen Endabschnittes der Flexfolie ist nicht zwingend erforderlich. Der Einsatz dieses Stützkörpers begünstigt jedoch, falls dieser eingeklebt oder eingebettet ist, in stabilisierender Weise den Fügevorgang der Flexfolie und gibt der Flexfolie eine gewisse Vorspannung und insbesondere eine feste Geometrie, so dass eine Ausbildung einer sicheren stoffschlüssigen Verbindung zwischen den elektrischen Kontakten, sei es ein Einzelkontakt, oder seien es eine Reihe von Kontakten und den freigelegten Leiterbahnen der Flexfolien gewährleistet ist.

Für den Fall, dass die Flexfolie an Ober- und Unterseite mit geschlossener Deckfolie versehen ist, können elektrische Kontaktstifte, die Teil einer Kontaktreihe sind und in den Kontaktschlitz eines Steuergerätegehäuses, sei es ein gemoldetes, sei es ein gebautes Gehäuse ragen, auch angespritzt werden. In diesem Falle wird die Flexfolie um den besagten Stützkörper gelegt und eine derart konfektionierte Flexfolie wird in den entsprechenden Kontaktschlitz der Elektronik eingesteckt. Beim Einstecken wird die außen liegende der Deckfolien von den elektrischen Kontaktstiften durchstochen. Im Stützkörper, welcher bei diesem Fügevorgang die rückseitige Deckschicht der als Schichtaufbau ausgebildeten Flexfolie abstützt, können unterhalb der Einstechstellen die elektrischen Kontaktstiftvertiefungen liegen, damit die elektrischen Kontaktstifte unter Aufbringung eines minimalen Kraftaufwandes in die Flexfolie eingestochen werden können, ohne den Stützkörper jedoch zu berühren. Wird der elektrische Kontaktstift bei Berührung mit den freigelegten Leiterbahnbereichen beispielsweise durch einen Laserstrahl stark erhitzt, so entsteht zwischen den freigelegten Bereichen und dem elektrischen Kontaktstift eine fest leitende Verbindung. Durch den Eintrag von Wärme mittels des Laserstrahles erfolgt ein Aufschmelzen der Materialien von Leiterbahnen zu einem elektrischem Kontaktstift, oder ein Aufschmelzen eines zuvor eingebrachten Lotes, das zum Beispiel beim Herstellen der Flexfolie bereits auf die Leiterbahnen, die freizulegen sind, partiell aufgebracht wurde bevor die Deckschicht aufgeklebt wird. Bei den elektrischen Kontaktstiften kann es sich zum Beispiel um spitz auslaufende Rundstäbe handeln, oder um flache Kontaktbleche, die eine scharfe Kontaktschneide aufweisen.

Statt eines fest eingebauten, mit dem offenen Endabschnitt der Flexfolie beispielsweise verklebten Stützkörpers, kann auch ein Montagewerkzeug in Gestalt eines Stützkörpers Verwendung finden und einen temporären Stützkörper darstellen. Durch einen als MontageWerkzeug ausgebildeten Stützkörper können einzelne Stützkörpersegmente gebildet werden, die kraftschlüssig dafür sorgen, dass jeder Leiterbahnstreifen individuell an den gegebenenfalls aufgrund von Fertigungstoleranzen unterschiedlich lang ausgefallenen elektrischen Kontaktstiftes, der im Kontaktschlitzspalt frei angedrückt wird und so sichergestellt werden kann, dass auch unter Berückschichtung von Herstellungstoleranzen zuverlässige stoffschlüssige Verbindungen zwischen den freigelegten Leiterbahnabschnitten der Flexfolie und den elektrischen Kontakten, seien es Einzelkontakte, seien es Kontakte in einer Kontaktreihe hergestellt werden können.

In einer alternativen Ausführungsvariante der erfindungsgemäß vorgeschlagenen Lösung können die flachen, elektrischen Kontakte mit einer scharfen Schneide auch relativ zur Ebene, in der sich die Flexfolie erstreckt, verdreht sein und eine U- oder V- förmige Aussparung beziehungsweise Ausstanzung aufweisen. Diese wird scharfkantig ausgelegt und schneidet in die Flexfolie beim Herstellen der stoffschlüssigen Verbindung, d. h. bei der Berührung des gebogenen Endabschnittes der Flexfolie mit den entsprechend mit einer scharfen Schneide versehenen elektrischen Kontakte ein. Einerseits lässt sich bei dieser Lösung ein Einschneiden dieser eine scharfe Schneide aufweisenden, flachen, elektrischen Kontakte in die Leiterbahnen oder bei einer beidseitig durch Deckfolien beziehungsweise Deckschichten geschlossenen Flexfolie durch Schneiden derselben erreichen. Die Herstellung der stoffschlüssigen Verbindung erfolgt wie oben stehend beschrieben. Die eine scharfe Schneide aufweisende, elektrische, beispielsweise aus flachem Blech hergestellten Kontakte, die in die Flexfolienoberfläche insbesondere in die Deckschicht bzw. die Deckfolie einschneiden, können gegenüber der Ebene der Flexfolie um einen bestimmten Winkel zwischen 0° und 90° schräg eingestellt sein. Diese schräge Einstellung bietet Vorteile hinsichtlich der Fokussierung eines Laserstrahles, mit dem ein Wärmeeintrag zur Herstellung der stoffschlüssigen Verbindung vorgenommen wird. Nach Herstellung der stoffschlüssigen Verbindung zwischen den elektrischen Kontakten des Steuergerätegehäuses und den freiliegenden Enden der Flexfolie innerhalb des Kontaktschlitzes des Steuergerätgehäuses, sei es eingebaut, sei es ein gemoldetes Gehäuse, sind nunmehr mechanische und elektrische Kontakte zwischen den beiden Partner hergestellt Nach Herstellen der stoffschlüssigen Verbindung können die blanken Metallteile zum Beispiel mit einem beständigen Lack oberflächenisoliert werden, damit im Falle des Einsatzes einer derart hergestellten elektrischen Verbindung in einer Umgebung zum Beispiel insbesondere in der Umgebung eines Kraftfahrzeuggetriebes im Öl oder im transmission fluid vorhandene Späne keine Kurzschlüsse erzeugen können. Der Hohlraum, innerhalb des Kontaktschlitzes, in dem die erfindungsgemäß vorgeschlagene stoffschlüssige Verbindung durch Warmeeintrag hergestellt werden kann, ist in und um die Kontaktstelle mit einer Isolationsmasse befüllt; ferner besteht die Möglichkeit, in den Hohlraum des Kontaktschlitzes Kunststoff einzubringen, oder eine silikonartige Masse dort zu isolations- und mechanischen Schutzzwecken vorzusehen.

In Weiterbildung des der Erfindung zugrunde liegenden Gedankens können die elektrischen Kontakte zum Beispiel über eine Vorumspritzung als Kontaktleiste vorkonfektioniert werden. Die Kontaktleiste - ausgebildet als ein Kunststoffkörper mit seitlich hervorstehenden hohen oder scharfkantigen ausgebildeten elektrischen Kontaktstiften oder Kontaktflächen - wird auf einer beidseitig mit einer Deckfolie bzw. Deckschicht versehenen Flexfolie aufgesteckt. Die scharfkantig oder eine Spitze aufweisenden Kontakte durchstechen dabei die Flexfolie. Diese wird dann zum Beispiel U-förmig um den gerundeten Kontaktleistenkörper herumgelegt bzw. mit dessen Außeroberfläche verklebt. Andererseits besteht die Möglichkeit, die Flexfolie auch in ihrer im wesentlichen sich glatt erstreckenden horizontal oder vertikal verlaufenden Ebene zu belassen und an den durchstochenen Enden der Kontaktstifte zu verschweißen. Der Kontaktleistenkörper - in der Regel als Kunststoffspritzgussmaterial gefertigt - dient in diesem Zusammenhang auch als Stützkörper für die geringe mechanische Festigkeit aufweisende Flexfolie.

Eine zum Beispiel in U-Form vorkonfektionierte Flexfolie wird nunmehr in den Kontaktschlitz eines Elektronikgehäuses, sei es ein gemoldetes Gehäuse, sei es ein gebautes Gehäuse eingesteckt bis ein Anschlag erreicht ist. Die Flexfolie wird über seitliche Ränder geführt. Über Öffnungen in den den Kontaktschlitz begrenzenden Gehäusebereichen ist die Berührstelle zwischen den die Flexfolie durchstochenen elektrischen Kontaktstiften und den Kontakten des Gehäuses zugänglich. Durch die Öffnungen, die an der Oberseite und an der Unterseite des gemoldeten oder gebauten Steuergerätgehäuses ausgebildet sein können, kann zum Beispiel in vorteilhafter Weise ein Laserstrahl eingekoppelt werden, der den Bereich an der Berührstelle zwischen den Kontaktstiften, welche die Flexfolie durchstochen haben, aufschmilzt und dort eine stoffschlüssige Verbindung sei es durch Löten, Schweißen oder dergleichen herstellt. Die beiden jeweils miteinander stoffschlüssig zu verbindenden elektrischen Kontakte können auch vorverzinnt sein, so kann zum Beispiel die gesamte Kontaktleiste vor dem Umspritzen mit Kunststoff zur Kontaktleiste komplett verzinnt sein, so dass eine Wärmequelle an der berührten Stelle die Teile miteinander verlötet. In diesem Fall schmilzt das Lot auch in Richtung zur Leiterbahn der Flexfolie auf, die ebenfalls während der Herstellung der Flexfolie im späteren Verbindungsbereich vorverzinnt ausgebildet sein kann. Aus der FR 2 860 945 A1 ist ein Verfahren zum Verbinden eines flexiblen Flachleiters mit einer Leiterplatte bekannt. Hierbei wird ein Lotdepot auf einer elektrisch leitfähigen Kontaktzone der Leiterplatte aufgebracht. Dieses Lotdepot der Leiterplatte wird anschließend mit einer elektrisch leitfähigen Kontaktzone, die auf der der Leiterplatte zugewandten Seite des Flachleiters vorhanden ist, in Berührung gebracht. Schließlich wird das Lötdepot der Leiterplatte durch eine Öffnung in der Kontaktzone des Flachleiters hindurch erwärmt, das Lot dadurch aufgeschmolzen und somit der Flachleiter mit der Leiterplatte verlötet. Dieses Verfahnen eignet sich für Verbindungen zwischen Leiterplatten und Flachleitem, die im Bereich der Kontaktstelle eben ausgebildet sind.

### Vorteile der Erfindung

Anstelle der obenstehend erwähnten Flexfolie kann auch ein Kabel oder ein Flachbahnkabel mit mehreren Litzen pro eingesetzt werden, welches durch die spitz ausgebildeten elektrischen Kontaktstifte durchstochen ist. Die Kontakte der Elektronikgehäuse, welche aus einem gemoldeten oder einem gebauten Gehäuse hervorstehen, können beispielsweise als flache Blechstreifen oder als Runddrähte ausgebildet sein, sind elektrisch leitend und lassen sich insbesondere verschweißen bzw. verlöten oder mittels eines Leitklebers verkleben. Die elektrischen Kontakte seien es flache Blechstreifen, seien es Rundstreifen können aus dem Gehäuse herausragen oder bündig mit der Gehäuseoberfläche ausgebildet sein. Im Falle abgedichteter Elektronikgehäuse beziehungsweise in einem Moldgehäuse aufgenommener elektronischer Schaltungsträger sind die Kontaktstifte im Gehäuse, sei es gemoldet, sei es gebaut oder sind in dieses eingespritzt. Die elektrischen Kontaktstifte können gegebenenfalls sich entsprechende Formgebung oder Materialausführung leicht federnd ausgebildet sein. Nach Ausbildung der stoffschlüssigen Verbindung wie oben stehend beschrieben, sind die Flexfolie und das zu kontaktierende Steuergerätegehäuse und die Zugentlastung mechanisch und elektrisch miteinander verbunden. Blank verbliebene Metallteile können nach Herstellen der stoffschlüssigen Verbindung zum Beispiel mit einem beständigen Lack oberflächenisoliert werden, damit im Falle des Einsatzes an einer Getriebesteuerung im Getriebefluid enthaltene Späne keine Kurzschlüsse hervorrufen können. Der Hohlraum innerhalb des Kontaktschlitzes um die Berührstelle und die Stelle herum, an der die stoffschlüssige Verbindung hergestellt wurde, kann mit einem Isolationsmaterial einer Isolationsmasse im eingespritzten Kunststoff oder einer silikonartigen Masse befüllt werden.

Bei der erfindungsgemäß vorgeschlagenen Lösung besteht in vorteilhafter Weise die Möglichkeit, diese einzeln und als prüfbare Baugruppe in einer Elektronikfertigung herzustellen, wobei alle Vorteile eines dicht ausgebildeten Moldgehäuses genutzt werden können. Als Aufbau- und Verbindungstechnik wird zur Kontaktierung der TCU die Flexfolie vorgesehen. Die Verbindung zwischen der TCU, d.h. dem Steuergerät und der Flexfolie erfolgt dann in einem deutlich kostengünstigeren Sauberraum Fertigungsbereich, so dass aus herstellungstechnischer Sicht kostenmäßig ungünstigere Reinraum umgangen werden kann. Ein gemoldet ausgebildetes Getriebesteuergerät (TCU) hat den Vorteil, dass kein Luftvolumen enthalten ist und dass somit keine Gefahr besteht, dass bei Temperaturwechsel Medium eindringen kann. Durch die erfindungsgemäß vorgeschlagene Lösung können die positiven Eigenschaften eines ummoldet ausgebildeten Steuergerätes (TCU) mit den Vorteilen einer Aufbauverbindungstechnik, die durch eine Flexfolie gebildet wird, verbunden werden. Durch die Umspritzung des Steuergerätes (TCU) mit einer Moldmasse kann kein Öl eingesaugt werden und in einem normalen Sauberraum unter kostengünstigeren Fertigungsbedingungen lässt sich dieses mit dem restlichen Modul im Wege der Flexfolienkontaktierung elektrisch verbinden.

### Kurze Beschreibung der Zeichnungen

Anhand der Zeichnungen wird die Erfindung nachstehend eingehender beschrieben.

Es zeigt:
- Figur 1: eine erste Ausführungsvariante der erfindungsgemäß vorgeschlagenen elektrischen Kontaktierung zwischen einem Steuergerät und einer Flexfolie,
- Figur 2: ein Vorstadium der elektrischen Kontaktierung mit eben ausgebildeter Flexfolie unterstützt durch einen gerundet ausgebildeten Stützkörper,
- Figur 3: eine außerhalb der Horizontalebene liegende Aufschmelzstelle zwischen einem offenen Endabschnitt einer Flexfolie und einem diesen berührenden elektrischen Kontakt,
- Figur 4: eine weitere Ausführungsvariante der elektrischen Kontaktierung zwischen einem elektrischen Kontakt eines Steuergerätegehäuses und einer durch einen Stützkörper abgestützte Flexfolie.
- Figur 4.1: ein federnder Kontakt mit Schneide,
- Figur 4.2: ein als angespitzter Rundstab ausgebildeter elektrischer Kontakt,
- Figur 5: einen Stützkörper zum Ausgleich unterschiedlicher Berührungsstellen zwischen elektrischen Kontakten und einer gebogen ausgebildeten Flexfolie, wobei der Stützkörper in dieser Ausführungsvariante ein überfedertes Werkzeug darstellt, der nur während des Verbindungsvorganges eingesetzt wird,
- Figur 6: ein Schnittverlauf gemäß des Schnittes VI - VI in Figur 5,
- Figur 7.1: freigelegte Leiter 7.2, 7.3, verschiedene Ausführungsformen von Leiterbahnen innerhalb der Leiterbahnschicht eines Schichtaufbaus der Flexfolie,
- Figur 8: einen elektrischen Kontakt mit Schneide,
- Figur 8.1: eine Draufsicht auf den elektrischen Kontakt mit Schnelde gemäß Figur 8,
- Figur 9, 9.1: eine elektrische Kontaktierung eines offenen Endabschnittes einer Flexfolie mit einem einer Schneide aufweisenden um 45° gedrehten elektrischen Kontakt,
- Figur 10: einen Schnitt durch einen Schaltungsträger, eingelassen in eine Moldmasse,
- Figur 10.1: einen Schnitt durch die Darstellung gemäß Figur 10 des Schaltungsträgers und Moldmasse
- Figur 11, 11.1: eine gespritzte Kontaktleiste zum Durchstechen einer eben ausgebildeten Flexfolie.
- Figur 12:: eine durchstochene Flexfolie zur Kontaktierung mit einem Steuergerät,
- Figur 13: eine weitere Ausbildungsmöglichkeit einer elektrischen Kontaktierung zwischen Flexfolie und Steuergerät und
- Figur 14: die Ausbildung einer Schweißzone zwischen einer Kontaktleiste der eine Flexfolie durchstochen hat und einen elektrischen Kontakt des Steuergerätes berührt.

### Ausführungsformen der Erfindung

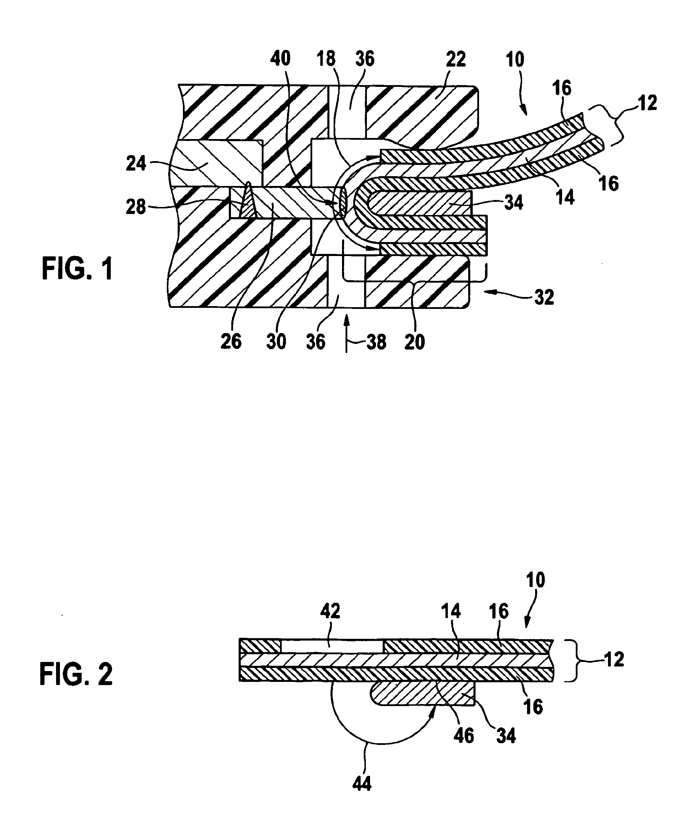

Darstellung gemäß Figur 1 ist eine erste Ausführungsvariante der erfindungsgemäß vorgeschlagenen elektrischen Kontaktierung zu entnehmen.

Figur 1 zeigt in teilweiser Schnittdarstellung eine Flexfolie 10 (FPC = Flexible Printed Circuit). die Flexfolie 10 weist einen Schichtaufbau 12 auf und umfasst eine mittig liegende schichtförmig ausgebildete Leiterbahn 14, die an Ober- und Unterseite von einer Deckschicht 16 umschlossen ist. Mit Bezugszeichen 20 ist ein Endabschnitt der Flexfolie 10 bezeichnet, der in der Ausführungsvariante gemäß Figur 1 eine Umlenkung 18 aufweist, die hier als eine 180° Umlenkung ausgeführt ist. Wie Figur 1 zeigt, ist der Endabschnitt 20 der Flexfolie 10 in der normal flach ebenen Gestalt hier um ca, 180° gebogen. Anstelle der in Figur 1 dargestellten 180° Zeichen betragenden Umlenkung 18 können auch Winkel von etwas größer als 0° bis zum 180° dargestellt werden oder der offene Endabschnitt 20 der Flexfolie 10 kann auch aufgerollt bis zu 360° gefaltet sein, derart, dass der offene Bereich der Deckschicht 16 die Leiterbahn 14 zugänglich macht. Aus der Darstellung gemäß Figur 1 geht hervor, dass die einem elektrischen Kontakt 26 zuweisende Seite des Schichtaufbaus 12 für eine bestimmte Länge komplett entfallen ist, so dass die unter der Deckschicht 16 liegende Leiterbahn 14 an eine Berührstelle 40 durch den elektrischen Kontakt 26, der seinerseits mit einem Schaltungsträger 24 elektrisch verbunden ist, berührt wird. Bezugszeichen 28 bezeichnet eine stoffschlüssige Verbindung zwischen dem elektrischen Kontakt 26 und dem Schaltungsträger 24, während eine stoffschlüssig ausgebildete elektrische Kontaktierung zwischen der Flexfolie 10 beziehungsweise deren Endabschnitt 20 und dem elektrischen Kontakt 26 in der Darstellung gemäß Figur 1 Bezugszeichen 30 identifiziert ist. Wie aus der Darstellung gemäß Figur 1 weiter hervorgeht, ist die elektrische Kontaktierung im Kontaktschlitz eines als Gehäuse 22 ausgebildeten hier aus Duroplast gemoldeten Gehäuses ausgeführt, wobei eine Wandung des Kontaktschlitzes, in dem der offene Endabschnitt 20 mit seiner Umlenkung 18 eingeführt wird, durch eine leicht gerundete Wandung auf der oberen Deckschicht 16 aufliegt.

Wie der Schnittdarstellung des Endabschnittes 20 mit Umlenkung 18 der Flexfolie 10 weiter entnommen werden kann, wird die Flexfolie in diesem Ausführungsbeispiel zur Herabsetzung der Zugbelastung und zur Erhöhung der mechanischen Steifigkeit an der Umlenkstelle durch einen Stützkörper 34 unterstützt. Der Einsatz des Stützkörpers 34 mit einer Halbkreis rund entsprechend der Vorderkante eines Tragflügels gerundeten Profilierung stützt die untere Deckschicht 16 des Schichtaufbaus 12 der Flexfolie 10 ab, so dass eine derart vorkonfektionierte Baugruppe aus Stützkörper 34 mit offenem Endabschnitt 20 mit Umlenkung 18 der Flexfolie 10 in den in Figur 1 dargestellten im Gehäuse 22 ausgebildeten Kontaktschlitz eingeführt werden kann, und zugentlastet, die in den Kontaktschlitz hineinragenden elektrischen Kontakte 26, seien es eine Kontaktreihe, sei es ein Einzelkontakt, an der Berührstelle 40 kontaktiert. Wie aus der Darstellung gemäß Figur 1 des weiteren hervorgeht, finden sich an der Oberseite des Gehäuses 22 und an der Unterseite des Gehäuses 22 Öffnungen 36, welche eine Zugänglichkeit der Berührstelle 40 sicherstellen. Durch die in Figur 1 dargestellten als Schlitze, als runde Öffnungen oder dergleichen konfektionierten ausgebildeten Öffnungen 36 erfolgt ein durch Bezugszeichen 38 angedeuteter Wärmeeintrag zum Beispiel in Gestalt eines Laserstrahles. Je nach Lage und Anzahl der Öffnungen 36 im Gehäuse 22 kann der Wärmeeintrag 38 von der Unterseite des Gehäuses her von der Oberseite des Gehäuses her oder sogar von der Unterseite und der Oberseite des Gehäuses gleichzeitig in Richtung auf die Berührstelle zwischen dem elektrischen Kontakt 26 und dem frei zugänglichen Bereich der Leiterbahn innerhalb der Umlenkung 18 erfolgen. Durch den Wärmeintrag 38 folgt ein Aufschmelzen der Materialien oder eines zuvor eingebrachten Lotes beispielsweise einer vorher verzinnten Leiterbahn 14 im Bereich der Berührstelle 40 so dass eine stoffschlüssige Verbindung zu einer elektrischen Kontaktierung 30 zwischen der Flexfolie 12 durch eine Flexfolie 10 im elektrischen Kontakt 26 führt. Statt der in Figur 1 gezeigten Flexfolie 10 kann auch ein Kabel, ein Flachbahnkabel oder anderes eingesetzt werden.

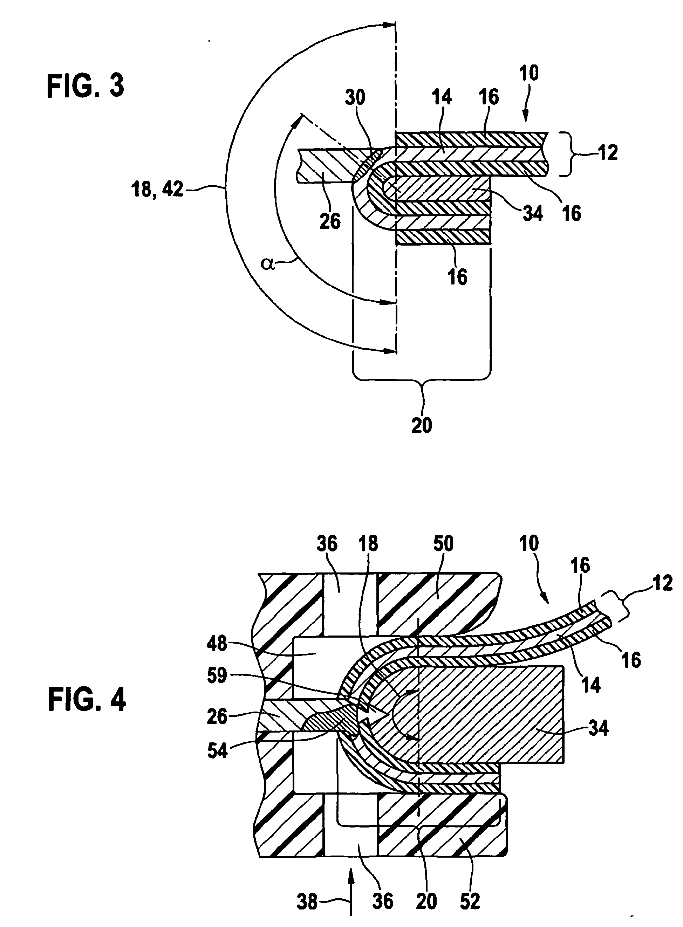

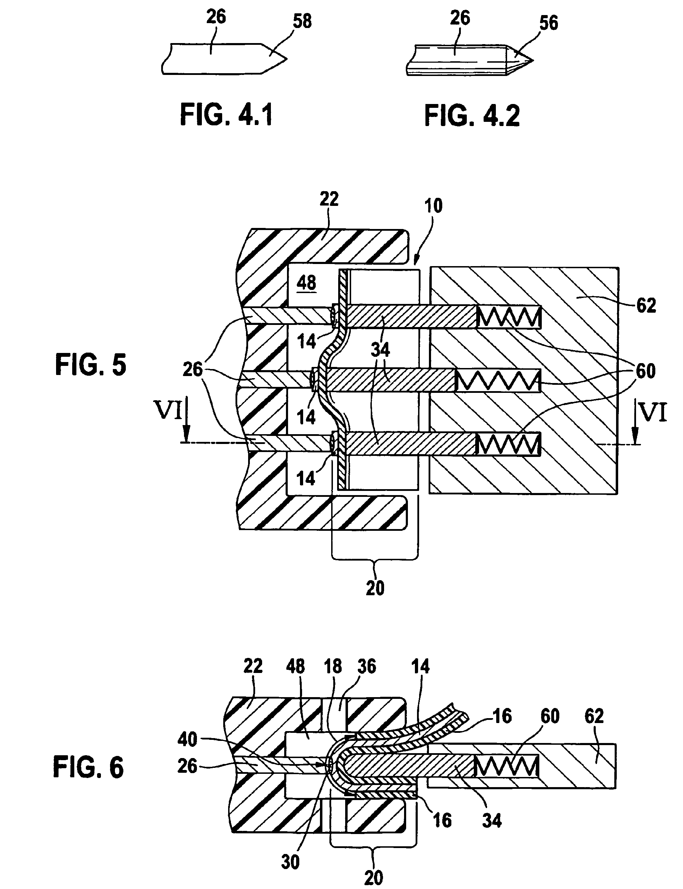

Wenngleich in der Darstellung gemäß Figur 1 nicht näher gezeigt, kann der elektrische Kontakt 26 als flacher Blechstreifen ausgebildet sein, oder es kann sich um einen Runddraht handeln, vergleiche weiter unten Figur 4.1 und 4.2.

Bezugszeichen 32 bezeichnet die Baueinheit aus Schaltungsträger 24 samt elektrischem Kontakt 26 und das hier durch eine Moldmasse gebildete Gehäuse 22 einer Transmission Control Unit, d.h. eines Getriebesteuergerätes oder eines Sensors oder dergleichen.

Der Darstellung gemäß Figur 2 ist eine Vorstufe der Konfektionierung der flach-ebenen Flexfolie zu entnehmen.

Aus der Darstellung gemäß Figur 2 geht hervor, dass die Flexfolie 10 den Schichtaufbau 12 aufweist, wobei die Leiterbahn 14 an Ober- und Unterseite jeweils von einer Deckschicht 16 überdeckt ist. Wie Figur 2 zeigt ist in der oberen der Deckschicht 16 eine Öffnung 42 ausgebildet, welche der 180° Umlenkung 18 - wie vorstehend im Zusammenhang mit Figur 1 beschrieben - entspricht.

Die unterhalb der Öffnung 42 liegende Länge der Leiterbahn 14 ist demzufolge frei zugänglich, d.h. auch elektrisch kontaktierbar. Die untere Deckschicht 16 ist ununterbrochen ausgebildet. An diese ist der optional einsetzbare mit einer halbkreisförmigen Rundung versehene Stützkörper 34 vorgesehen. Entlang einer Fuge 46 kann der Stützkörper 34 auch mit der unteren durchgehend ausgebildeten Deckschicht 16 des Schichtaufbaus 12 der Flexfolie 10 gefügt sein. Bezugszeichen 44 zeigt die Umlenkung der Flexfolie sobald diese um die gerundete Kante des Stützkörpers 34 in Richtung des in Figur 2 dargestellten Pfeiles gebogen wird, so dass Stützköper 34 vollständig von der unteren, ununterbrochen ausgebildeten Deckschicht 16 des Schichtaufbaus 12 der Flexfolie 10 umschlossen ist.

Figur 3 zeigt eine weitere Ausführungsvariante der erfindungsgemäß vorgeschlagenen elektrischen Kontaktierung zwischen einem elektrischen Kontakt und einem Endabschnitt einer Flexfolie.

Wie Figur 3 entnommen werden kann, liegt in dieser Ausführungsvariante einer elektrischen Kontaktierung 30 der zu kontaktierende elektrische Kontakt 26 leicht oberhalb einer Mittenebene, die durch den umgebogen ausgebildeten offenen Endabschnitt 20 der Flexfolie 10 verläuft. In diesem Falle würde - vergleiche Darstellung gemäß Figur 1 - durch die obere der beiden Öffnungen 36 in Gehäuse 22 des Getriebesteuergerätes 32 (TCU) ein Wärmeintrag 38 erfolgen. Bei Einkopplung eines Laserstrahles an der oberen der Öffnungen 36 im Gehäuse 22 entsteht die stoffschlüssige Verbindung 30 gemäß der Ausführungsvariante in Figur 3 auf der Oberseite - siehe auch die hier 180° betragende Umlenkung 18 des Endabschnittes der Folie. Der Winkel α zeigt, dass dieser in Bezug auf die Vertikale 130° beträgt, dieser kann je nach Erfordernis auch einen anderen Wert zwischen 0° und 180° annehmen. Abhängig von den gewählten Winkeln α wird die stoffschlüssige Verbindung 30 zwischen dem elektrischen Kontakt 26 und den freiliegenden Leiterbahnen 14 des Endabschnittes 20 der Flexfolie 10 durch entsprechende Einkopplung von Wärme an eine der Öffnungen 36 im Gehäuse 22 des Steuergerätes 32 vorgenommen.

Aus der Darstellung gemäß Figur 4 geht eine weitere Ausführungsmöglichkeit der erfindungsgemäß vorgeschlagenen elektrischen Kontaktierung zwischen elektrischen Kontakten eines Steuergerätegehäuses und einem offenen Endabschnitt eine Flexfolie hervor.

Im Unterschied zur in Figur 1 dargestellten Ausführungsvariante der elektrischen Kontaktierung 30 sind die in Figur 4 dargestellten elektrischen Kontakte entweder wie in Figur 4 Punkt 1 angedeutet als flache Kontakte mit Schneide 58 ausgebildet, oder aber als Rundstäbe ausgebildet, die eine runde Spitze 56 aufweisen. In Abwandlung der in Figur 1 dargestellten Ausführungsvariante der erfindungsgemäß vorgeschlagenen elektrischen Kontaktierung ist in der Ausführungsvariante gemäß Figur 4 die obere Deckschicht 16, welche die Leiterbahn 14 im Bereich der Umlenkung 18 überdeckt, nicht entfernt, sondern wird entweder von der flachen Schneide 58 des elektrischen Kontaktes 26 eingeschnitten oder von der Rundspitze 56 (Figur 4.2) der elektrischen Kontakte, wie in Figur 4 dargestellt, komplett durchstoßen. Im Bereich 54, welcher eine Aufschmelzzone darstellt, kann dann durch Warmeeinkopplung über eine oder beide der Öffnungen 36 einer oberen Begrenzung 50 beziehungsweise einer unteren Begrenzung 52 eines Freiraumes 48, der den Kontaktschlitz darstellt, ein Wärmeintrag erfolgen so dass eine Aufschmetzung eventuell eingebrachten Lotes oder vorher verzinnten Lotes auf der Leiterbahn 14 erfolgt, und es zur Ausbildung der stoffschlüssigen Verbindung zur Herstellung der elektrischen Kontaktierung 30 zwischen dem elektrischen Kontakt 26 und der Leiterbahn 14 der Flexfolie 10 kommt. Auch in dieser Ausführungsvariante ist der Endabschnitt 20 der Flexfolie 10 um den Stützkörper 34 gebogen, und der derart vorkonfektionierte Endabschnitt 20 der Flexfolie 10 wird in den Freiraum 48 gesteckt. Die außen liegende Deckschicht 16 wird von den elektrischen Kontakten 26, 58, 56 durchstochen, wobei durch Vertiefungen 59 im Stützkörper 34 sichergestellt ist, dass die elektrischen Kontakte 26 mit minimalem Kraftaufwand in die Flexfolie 10 eingestochen werden, ohne dass diese den Schutzkörper 34 berühren

In der Ausführungsvariante gemäß Figur 5 ist eine Abwandlung des Stützkörpers gemäß der vorstehend beschriebenen Figuren 1, 2 und 4 dargestellt, In der in Figur 5 dargestellten Ausführungsvariante handelt es sich um einen Stützkörper 62, der ein Montagewerkzeug darstellt, und einen temporären Stützkörper bildet, da dieser nur bei Herstellung der elektrischen Kontaktierung die Flexfolie 10 abstützt. Der Stützkörper 62 umfasst eine Anzahl von ausfahrbaren Stützkörpersegmenten 34, die jeweils durch ein Federelement 60 beaufschlagt sind. Die Stützkörpersegmente sind an die Rückseite der Flexfolie 10 angestellt, so dass jeder Leiterbahnstreifen 14 individuell an die gegebenenfalls aufgrund von Bauteil und Einbautoleranzen unterschiedlich langen elektrischen Kontakt 26, die aus dem Gehäuse 22 in den Freiraum 48 hineinragen, spaltfrei angedrückt wird. Wird die Spaltfreiheit zwischen den elektrischen Kontakten 26 und den freiliegenden Leiterbahnen so lange aufrecht erhalten, wie die Erzeugung der stoffschlüssigen Verbindungsherstellung der elektrischen Kontaktierung 30 dauert, lassen sich auch bei große Bautelltoleranzen aufweisende Komponenten zuverlässig elektrische Kontaktierungen 30 erzeugen.

Figur 6 zeigt den Schnittverlauf VI-VI - wie er in Figur 5 eingezeichnet ist. Aus der Darstellung gemäß Figur 6 geht hervor, dass die Federn 60 die Stützkörpersegmente 34 an der Rückseite der geschichtet aufgebauten Flexfolie 10 anstellen, die die Umlenkung 18 am Endabschnitt 20 aufweist. Die Umlenkung 18 beträgt in der Variante gemäß Figur 6 ca. 180°. Aufgrund der Federbeaufschlagung der Stützkörper 34 durch die Federelemente 60 Ist an der Berührstelle 40, d.h. an der Stelle, an der die elektrische Kontaktierung 30 als stoffschlüssige Verbindung hergestellt wird, ein spaltfreier Kontakt zwischen den elektrischen Kontakten 26 und der freiliegenden Leiterbahn 14 gewährleistet.

Aus den Ausführungsvarianten 7.1, 7.2 und 7.3 gehen freiliegende Leiterbahnbereiche, die an einer einen Schichtaufbau aufweisenden Flexfolie ausgebildet werden können, hervor.

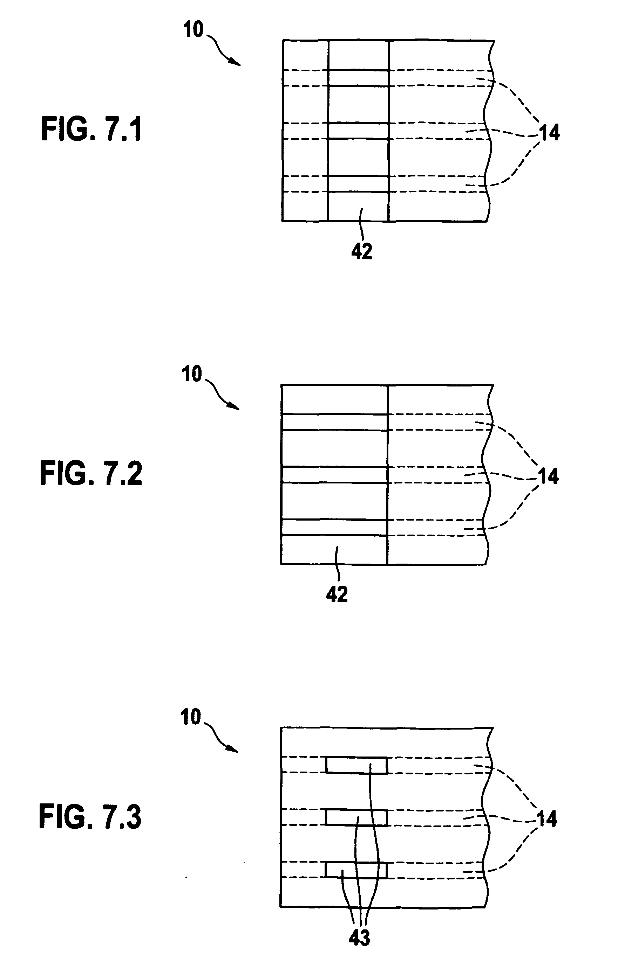

Figur 7.1 zeigt zum Beispiel eine flach eben aufweisende Gestalt annehmende Flexfolie 10, in die Leiterbahnen 14 eingelassen sind, in Figur 7.1 gestrichelt angedeutet. Innerhalb einer streifenförmigen Öffnung 42 sind einzelne der Breite des Streifens 42 entsprechende Abschnitte der Leiterbahnen 14 frei zugänglich, so dass bei entsprechender Kontaktierung mit einem elektrischen Kontakt 26 an der Berührstelle 40 dort eine stoffschlüssige Verbindung zur Herstellung einer elektrischen Kontaktierung 30 erzeugt werden kann. In der Ausführungsvariante gemäß Figur 7.2 liegt der Streifen 42 im Endabschnitt 20 der Flexfolie der hier in der Zeichnung liegenden Flexfolie und bleibt daher frei zugänglich. Der Darstellung gemäß Figur 7.3 ist zu entnehmen, dass die einzelnen Leiterbahnen 14 der Flexfolle 10 gemäß der Darstellung In Figur 7.3 nur durch Öffnungen 43, die der Breite der Leiterbahn 14 entsprechen, zugänglich sind. Aus den Ausführungsvarianten gemäß der Figuren 7.1, 7.2. und 7.3 geht hervor, dass die Deckschicht 16 am Ende der Flexfolie 10 für eine bestimmt Länge oder komplett entfallen kann, oder ein Streifen 42 über die gesamte Breite der Flexfolie 10 freigelegt wird, wie dies in Figur 7.1 dargestellt ist. Einzelne Bereiche vgl. Figuren 7.2 und 7.3 lassen sich oberhalb der Leiterbahnen 14 ebenso freilegen, wobei die Breite der Öffnungen jeweils kleiner, gleich groß oder größer als die Breite der Leiterbahn 14 gewählt werden kann.

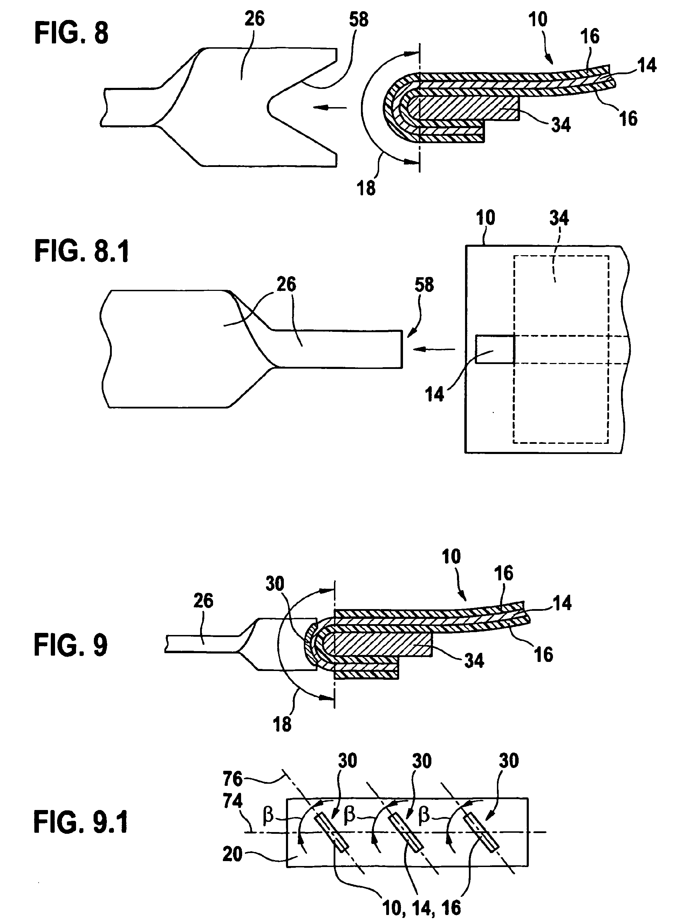

Der Darstellung gemäß Figur 8 ist zu entnehmen, dass ein elektrischer Kontakt 26 an seiner Vorderseite eine scharfkantig ausgebildete flache Schneide 58 aufweist. Die Schneide 58 ist dreieckförmig konfiguriert und komplementär zur hier bogenförmig ausgebildeten Umlenkung 18 des Endabschnittes 20 der Flexfolie 10 gestaltet. Die Flexfolie 10 ebenfalls als Schichtaufbau aus Leiterbahn 14 und Deckschichten 16 an Ober- und Unterseite beschaffen wird durch den Stützkörper 34 abgestützt. Wird die vorkonfektionierte Flexfolie 10 mittels des Stützkörpers 34 gemäß des Pfeiles in die Schneide 58 eingeschoben, so entsteht eine elektrisch leitende Verbindung zwischen dem elektrischen Kontakt 26 bzw. dessen Schneide 58 und dem offen liegenden Bereich der Leiterbahn 14 der Flexfolie 10 unterstützt durch den Stützkörper 34. Die gemäß Figur 8 hergestellte elektrische Verbindung wird, nachdem die Schneide 58 des elektrischen Kontaktes 26 in die Flexfolie 10 eingeschnitten hat, durch eine stoffschlüssige Verbindung, so zum Beispiel in Gestalt einer Laserschweißung hergestellt.

Den Darstellungen gemäß der Figuren 9 und 9.1 ist eine beispielsweise um einen Winkel β von 45° verschränkte elektrische Kontaktierung zwischen einem eine Einschneidkante aufweisenden Kontakt und einer eine Umlenkung aufweisenden Flexfolie zu entnehmen.

Aus der Darstellung gemäß Figur 9 geht hervor, dass in dieser Ausführungsvariante die Flexfolie 10 ebenso die Umlenkung 18 aufweist, die in eine Schneide 58 des elektrischen Kontaktes 26 eingeschoben wird und anschließend eine elektrische Kontaktierung 30 durch eine stoffschlüssig Verbindung hergestellt wird. Aus der Draufsicht gemäß Figur 9.1 geht hervor, dass in dieser Ausführungsvananten ein Schränkungswinkel β ca. 45° beträgt, d.h. die Ebene der Flexfolie vgl. Bezugszeichen 74 ist um diesen Schränkungswinkel β in Bezug auf die Kontaktierungsebene 76 verdreht. Anstelle des in Figur 9 dargestellten Schränkungswinkels β von 45°, lassen sich auch größere oder kleinere Winkel in Bezug auf die Ausbildung der elektrischen Kontaktierungen 30 als in Figur 9 eingezeichnet, darstellen.

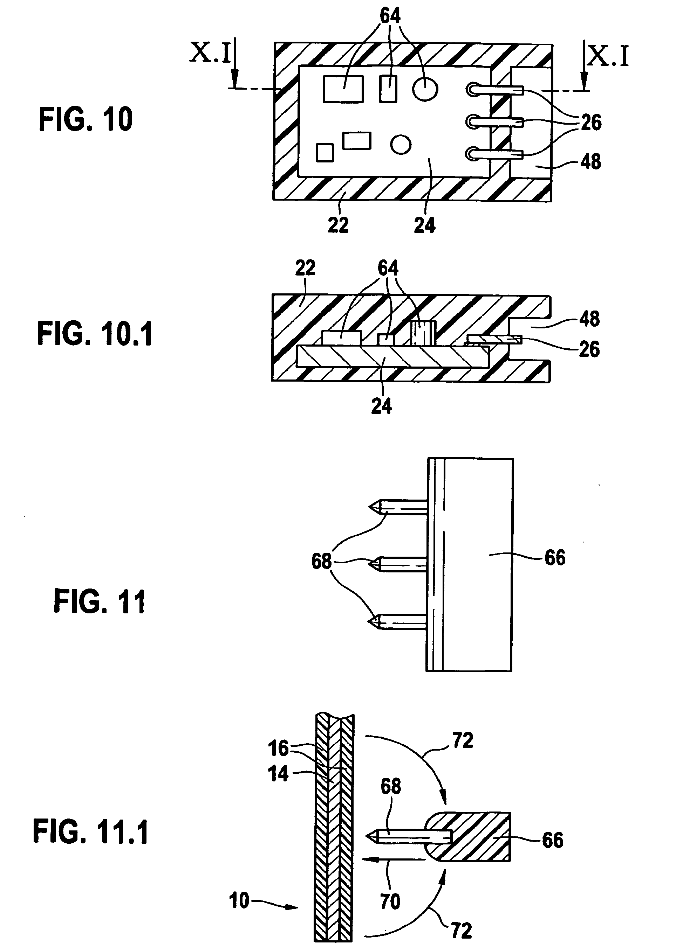

Figur 10 zeigt die Draufsicht auf ein Steuergerät, welches aus Moldmasse hergestellt ist.

Der Draufsicht gemäß Figur 10 ist zu entnehmen, dass der Schalterungsträger 24 mit einer Anzahl von darauf aufgenommenen elektronischen Bauelementen 64 von der Moldmasse 22 umschlossen ist. Durch einen Steg der Moldmasse 22 ragen elektrische Kontakte 26 in den Freiraum 48, welcher den Kontaktierungsschlitz des in Figur 10 teilweise geschnitten dargestellten Gehäuses des Steuergerätes beispielsweise eines Getriebesteuergerätes (TCO) dargestellt. Die elektrischen Kontakte 26, die in den Freiraum 48 hineinragen, sind dort frei zugänglich.

Der Darstellung gemäß Figur 10.1 ist ein Schnitt durch die Ebene XI - XI der Figur 10 zu entnehmen, aus dem hervorgeht, dass der Schaltungsträger 24 mit an dessen Oberseite aufgenommenen Bauelementen 64 vollständig von der Moldmasse 22 umschlossen ist und lediglich die Spitzen der elektrischen Kontakte 26 in den Freiraum 48 hinragen, welcher den Kontaktschlitz darstellt.

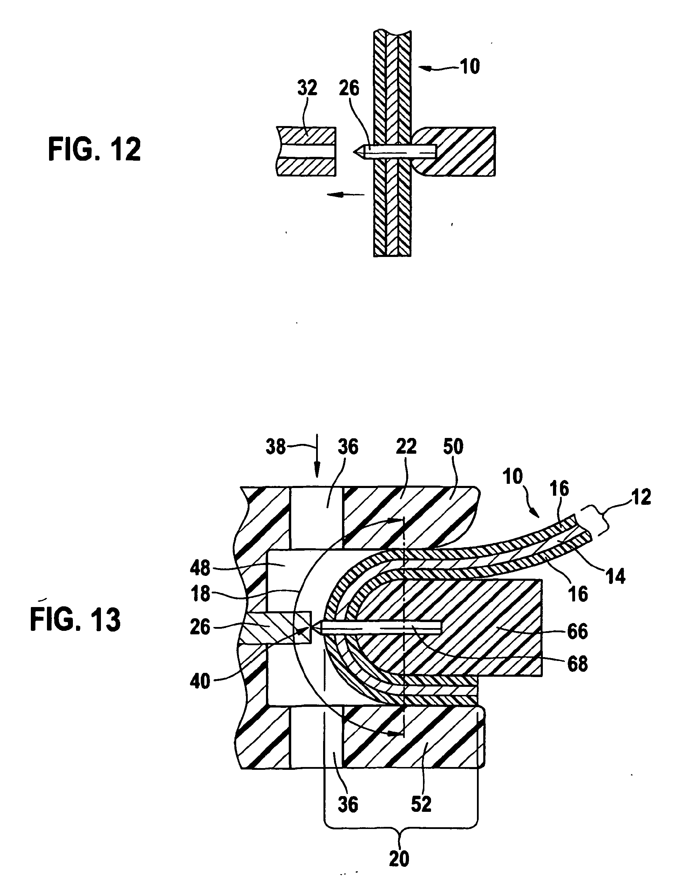

Den Figuren 11 und 11.1 ist zu entnehmen, dass eine beidseitig geschlossene Flexfolie 10 auf eine Kontaktleiste 66 aufgesteckt wird. In der Kontaktleiste 66 sind eine Anzahl von Einzelkontakten 68 von einem Kunststoffmaterial umschlossen. Lediglich die vorderen gegebenenfalls vorverzinnten Enden der elektrischen Einzelkontakte 68 stehen über den Körper der Kontaktleiste 66 gemäß Figur 11 hervor. Figur 11.1 zeigt, dass die vorstehenden gegebenenfalls vorverzinnten Enden der Einzelkontakte 68 eine sich im Wesentlichen ununterbrochen in Längsrichtung erstreckende Flexfolie durchstechen. Die Flexfolie umfasst ununterbrochen ausgebildete Deckschichten 16, welche die Schicht, die die Leiterbahn 14 darstellt, überdecken. Nach Durchstechen der im Wesentlichen sich in vertikaler Richtung erstreckenden Flexfolie 10 können die verbleibenden Enden der Flexfolie 10 beidseits der Einstichstelle um das Material der Kontaktleiste 26 gebogen bzw. herumgelegt und dort verklebt werden. Die Flexfolie 10 kann andrerseits - wie auch in Figur 12 angedeutet - in ihrer ebenen Form verbleiben und dann elektrische Kontakte 26 angeschweißt bzw. anderweitig stoffschlüssig gefügt werden, in diesem Falle der Ausführungsvariante gemäß Figuren 11 und 11.1 dient der Körper der Kontaktleiste 66 als Stützkörper wie in Zusammenhang mit den vorstehenden Ausführungsvarianten bereits mehrfach erwähnt.

Aus der Darstellung gemäß Figur 13 geht hervor, dass eine vorkonfektionierte, hier eine U-Form aufweisende Umlenkung 18 am Endabschnitt 20 der den Schichtaufbau 12 aufweisenden Flexfolie 10 ausgebildet ist. Eine derart vorkonfektionierte Flexfolie wird um die Kontaktleiste 66 herumgelegt und von den Einzelkontakten 68 vollständig durchstochen, in den Freiraum 48 des Gehäuses 22 eingeschoben. Wie aus Figur 13 hervorgeht, ist die Deckschicht 16, welche die Leiterbahn 14 entlang der Umlenkung 18 überdeckt nicht entfernt, sondern lediglich vom Einzelkontakt 68 durchstoßen, der die Stirnseite des in den Freiraum 48 hineinragenden elektrischen Kontakte 26 an der Berührstelle 40 berührt.

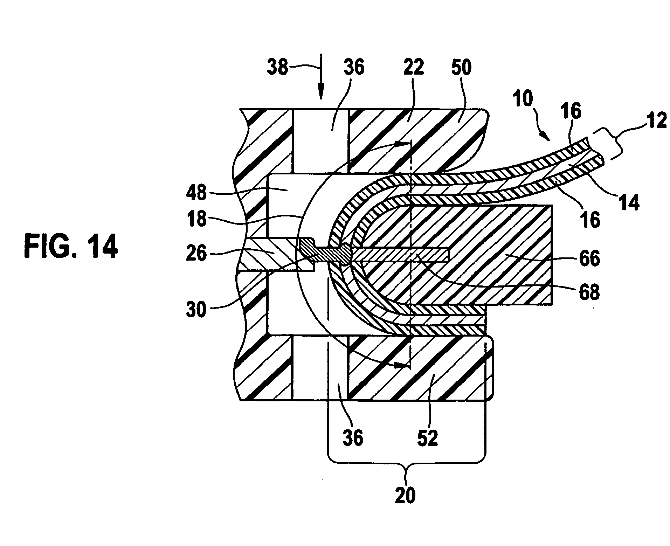

In Figur 14 ist dargestellt, dass bei einem Wärmeeintrag über die Öffnung 36, die sich in der oberen Begrenzung 50 befindet, eine elektrische Kontaktierung 30 zwischen dem elektrischen Kontakt 26 des spitz auslaufenden Endes des Einzelkontaktes 68 erfolgt, der die Flexfolie, d.h. sämtliche Schichten 14 und 16 des Schichtaufbaus 12 durchstochen hat. Für den Fall, dass der Einzelkontakt 68 vorverzinnt ist, kann durch Wärmeeintrag über die oberen Öffnungen 36 in der oberen Begrenzung 50 eine elektrische Kontaktierung 30 beispielsweise durch eine Lötverbindung hergestellt werden. Das Lot schmilzt in diesem Falle auch in Richtung zur Leiterbahn 14 der Flexfolie 10 auf, die ebenfalls während der Herstellung im späteren Verbindungsbereich, d.h. im Bereich der sich später einstellenden Berührstelle 40 vorverzinnt ausgebildet sein kann. Statt einer Flexfolie 10 - wie in Figur 13 und 14 dargestellt - können auch Kabel oder Flachbandkabel mit mehreren Litzen pro Ader verwendet werden, durch das die spitzen Enden der elektrischen Einzelkontakte 68 durchgestochen werden und somit auch elektrisch mit den Litzen In Verbindung geraten. Die elektrischen Kontakte 26 im Gehäuse des Steuergerätes können als flacher Blechstreifen oder eben als Runddrähte ausgebildet sein, vgl. Figuren 4.1, 4.2 oder auch Figuren 8, weisen elektrisch leitende Eigenschaften auf, und sind sowohl schweiß- als auch verlötbar und lassen sich mit einem Leitkleber verkleben. Die elektrischen Kontakte 26 können aus dem Steuergerätegehäuse 22 herausragen oder bündig mit der Gehäuseoberfläche verlaufen. Im Falle vollständig abgedichteter Elektroniken sind die elektrischen Kontakte 26 in das Gehäuse 22 dicht eingelassen oder in dieses eingespritzt. Durch entsprechende Formgebung können die elektrischen Kontakte 26 gegebenenfalls auch Federeigenschaften aufweisen. Nach Herstellung der elektrischen Kontaktierung 30 im Wege der stoffschlüssigen Verbindung wie erfindungsgemäß vorgeschlagen sind die Elektronik, d.h. die elektronischen Komponenten 64 des Schaltungsträgers 24 mit dem Endabschnitt 20 der Flexfolie 10 sowohl mechanisch als auch elektrisch leitend fest verbunden. Eventuell verbleibende blanke Metallteile können nunmehr, d.h. nach Herstellung der elektrischen Kontaktierung 30 mit einem beständigen Lack oberflächenisoliert werden, damit im Falle des Einsatzes im Rahmen einer Getriebesteuerung im Getriebefluid eventuell vorhandene Späne keine Kurzschlüsse erzeugen können. Der in den Darstellungen gemäß der Figuren 10, 10.1 und 13 sowie 14 gezeigte Freiraum 48 kann gegebenenfalls um die stoffschlüssige und die elektrische Kontaktierung 30 herum mit einer Isoliermasse, einer Kunststoffmasse oder einer silikonartigen Masse verfüllt werden, die über die Öffnungen 36, über die zuvor der Wärmeeintrag 38 erfolgt ist, eingeführt werden kann.

## Patentansprüche

1. Elektrische Kontaktierung (30) insbesondere zwischen einer mindestens einer Leiterbahn (14) aufweisenden Flexfolie (10) und mindestens einem elektrischen Kontakt (26, 68) eines Sensors oder eines Steuergerätes (32), wobei ein Endabschnitt (20) der Flexfolie (10) an einer Berührstelle (40) durch Wärmeeintrag (38) elektrisch kontaktiert (30) ist, **dadurch gekennzeichnet, dass** der Endabschnitt (20) der Flexfolie (10) an der Berührstelle (40) an vorstehend ausgebildete elektrische Kontakte (26, 68) angestellt ist.

2. Elektrische Kontaktierung gemäß Anspruch 1 **dadurch gekennzeichnet, dass** die elektrischen Kontakte (26, 68) mit einem Schaltungsträger (24) kontaktiert sind, und in einen Freiraum (48) eines Gehäuses (22) vorstehen oder aus einer Kontaktleiste (66) herausragen.

3. Elektrische Kontaktierung gemäß Anspruch 1 **dadurch gekennzeichnet, dass** der Endabschnitt (20) der Flexfolie (10) als Wellenschlag insbesondere als Umlenkung (18) ausgebildet ist.

4. Elektrische Kontaktierung gemäß Anspruch 3 **dadurch gekennzeichnet, dass** die Umlenkung (18) in einem Winkel zwischen 0° und 270°, insbesondere von 180° ausgeführt ist.

5. Elektrische Kontaktierung gemäß Anspruch 3 **dadurch gekennzeichnet, dass** die Flexfolie (10) im Bereich der Umlenkung (18) eine Öffnung (42) in einer Deckschicht (16) aufweist, oder dass die Deckschicht im Bereich der Umlenkung vollständig oder
teilweise entfernt ist.

6. Elektrische Kontaktierung (30) gemäß Anspruch 1 **dadurch gekennzeichnet, dass** die Flexfolie 10 entlang der Umlenkuttg 18 durch einen Stützkern (34) bzw. Stützkemsegmente (34) abgestützt ist.

7. Elektrische Kontaktierung (30) gemäß Anspruch 1 **dadurch gekennzeichnet, dass** die elektrischen Kontakte (26, 68) als Rundspitzen (56) aufweisende Runddrähte oder flasche Schneiden (58) enthaltende Kontaktbleche ausgeführt sind:

8. Elektrische Kontaktierung (30) gemäß einem der vorhergehenden Ansprüche **dadurch gekennzeichnet, dass** die Ebene (74) der einen Schichtaufbau (12) aufweisenden Flexfolie (10) in Bezug auf eine Kontaktierungsebene (76) um einen Schränkungswinkel β verschränkt ist.

9. Elektrische Kontaktierung (30) gemäß dem vorhergehenden Anspruch **dadurch gekennzeichnet, dass** der Schränkungswinkel β zwischen 0° und 90° vorzugsweise zwischen 20° und 50° liegt.

10. Elektrische Kontaktierung gemäß einem der vorgehenden Ansprüche **dadurch gekennzeichnet, dass** mindestens eine Leiterbahn (14) der Flexfolie (10) vorverzinnt ist oder mit einem aufschmelzbaren innerhalb einer Aufschmelzzone (54) aufschmelzbaren Material versehen ist.

11. Elektrische Kontaktierung gemäß einem der vorhergehenden Ansprüche **dadurch gekennzeichnet, dass** die Berührstelle (40) zwischen dem elektrischen Kontakt (26) und dem frei liegenden Bereich der Leiterbahn (14) der den Schichtaufbau (12) aufweisenden Flexfolie (10) In einem Winkel α zwischen 0° und 180° liegt, insbesondere in einem Winkelbereich zwischen 30° und 150°.

12. Elektrische Kontaktierung gemäß einem der vorhergehenden Ansprüche, **dadurch gekennzeichnet, dass** der elektrische Kontakt (26) an der Berührstelle (40) einen ununterbrochenen Schichtaufbau (12) der Flexfolie (10) zwei Deckschichten und eine von diesen überdeckte Leiterbahn (14) umfassend durchsticht, vollständig durchsticht.

13. Elektrische Kontaktierung gemäß einem der vorhergehenden Ansprüche **dadurch gekennzeichnet, dass** die Öffnungen (42) innerhalb der die Leiterbahnen (14) der Flexfolie (10) zugänglich sind, über die gesamte Breite der Flexfolie (10) verlaufen, oder einzelne Bereiche über den Leiterbahnen (14) überdecken, wobei die Breite der Öffnungen (42) kleiner, gleich groß oder größer als die Breite der Leiterbahnen (14) ist.

14. Verfahren zur Herstellung einer elektrischen Kontaktierung (30) gemäß nachfolgenden Verfahrensschritten:
a) Erzeugung einer Umlenkung (18) an einem Endabschnitt (20) einer einen Schichtaufbau (12) aufweisenden Folie (10),
b) Freilegen von mindestens einer Leiterbahn (14) in der Flexfolie (10),
c) Einführen des offenen des die Umlenkung (18) aufweisenden Endabschnittes (20) der Flexfolie (10) in einen Kontaktierungsbereich (48),
d) Erzeugen eines Wärmeeintrages (38), der auf eine Berührstelle (40) zwischen mindestens einem elektrischen Kontakt (26) und den freiliegenden Bereichen der Leiterbahnen (14) gerichtet ist zur Erzeugung einer stoffschlüssigen Verbindung als elektrische Kontaktierung (30).

15. Verfahren gemäß dem vorhergehende Anspruch **dadurch gekennzeichnet, dass** der Wärmeeintrag (18) an der Berührstelle (40) von oben, von unten oder gleichzeitig von oben und unten erfolgt.

16. Verfahren gemäß einem der vorhergehenden Ansprüche **dadurch gekennzeichnet, dass** die elektrische Kontaktierung (30) an einer Berührstelle (40) erzeugt wird, die in Bezug auf die Vertikale in einem Endabschnitt in einem Winkel α zwischen 0° und 180°, insbesondere zwischen 20° und 160° liegt.

## Claims

1. Electrical contact-making (30), in particular between a flexible printed circuit (10) having at least one conductor track (14) and at least one electrical contact (26, 68) of a sensor or of a control device (32), wherein electrical contact is made (30) with an end section (20) of the flexible printed circuit (10) at a contact point (40) by the introduction (38) of heat, **characterized in that** the end section (20) of the flexible printed circuit (10) is positioned on previously formed electrical contacts (26, 68) at the contact point (40).

2. Electrical contact-making according to Claim 1, **characterized in that** a circuit mount (24) makes contact with the electrical contacts (26, 68), and the electrical contacts protrude into a free space (48) in a housing (22) and project out of a contact strip (66).

3. Electrical contact-making according to Claim 1, **characterized in that** the end section (20) of the flexible printed circuit (10) is in the form of a shaft eccentricity, in particular in the form of a deflection (18).

4. Electrical contact-making according to Claim 3, **characterized in that** the deflection (18) is designed with an angle of between 0 ° and 270 °, in particular of 180°.

5. Electrical contact-making according to Claim 3, **characterized in that** the flexible printed circuit (10) has an opening (42) in a covering layer (16) in the region of the deflection (18), or **in that** the covering layer is completely or partially removed in the region of the deflection.

6. Electrical contact-making (30) according to Claim 1, **characterized in that** the flexible printed circuit (10) is supported by a supporting core (34) or supporting core segments (34) along the deflection (18).

7. Electrical contact-making (30) according to Claim 1, **characterized in that** the electrical contacts (26, 68) are designed as round wires which have round tips (56) or metal contact plates which contain flat blades (58).

8. Electrical contact-making (30) according to one of the preceding claims, **characterized in that** the plane (74) of the flexible printed circuit (10) which has a layer structure (12) is angled in relation to a contact-making plane (76) by a setting angle β.

9. Electrical contact-making (30) according to the preceding claim, **characterized in that** the setting angle β is between 0° and 90°, preferably between 20° and 50°.

10. Electrical contact-making according to one of the preceding claims, **characterized in that** least one conductor track (14) of the flexible printed circuit (10) is pre-tin-plated or is provided with a fusible material which is fusible within a fusing zone (54).

11. Electrical contact-making according to one of the preceding claims, **characterized in that** the contact point (40) between the electrical contact (26) and the exposed region of the conductor track (14) of the flexible printed circuit (10) which has the layer structure (12) is at an angle a of between 0° and 180°, in particular in an angle range of between 30° and 150°.

12. Electrical contact-making according to one of the preceding claims, **characterized in that** the electrical contact (26) pierces, completely pierces, an uninterrupted layer structure (12) of the flexible printed circuit (10), comprising two covering layers and a conductor track (14) which is covered by said covering layers, at the contact point (40).

13. Electrical contact-making according to one of the preceding claims, **characterized in that** the openings (42), within which the conductor tracks (14) of the flexible printed circuit (10) are accessible, run over the entire width of the flexible printed circuit (10), or cover individual regions above the conductor tracks (14), wherein the width of the openings (42) is less than, equal to or greater than the width of the conductor tracks (14).

14. Method for establishing electrical contact-making (30) in line with the following method steps:
a) producing a deflection (18) at an end section (20) of a printed circuit (10) which has a layer structure (12),
b) exposing at least one conductor track (14) in the flexible printed circuit (10),
c) inserting the open end section (20), which has the deflection (18), of the flexible printed circuit (10) into a contact-making region (48),
d) generating an introduction (38) of heat which is directed at a contact point (40) between at least one electrical contact (26) and the exposed regions of the conductor tracks (14) in order to establish a cohesive connection as electrical contact-making (30).

15. Method according to the preceding claim, **characterized in that** the introduction (18) of heat at the contact point (40) is performed from above, from below or simultaneously from above and below.

16. Method according to one of the preceding claims, **characterized in that** the electrical contact-making (30) is established at a contact point (40) which is at an angle a of between 0° and 180°, in particular between 20° and 160°, in relation to the vertical in an end section.

## Revendications

1. Mise en contact électrique (30) notamment entre une feuille flexible (10) comportant au moins une piste conductrice (14) et au moins un contact électrique (26, 68) d'un capteur ou d'un appareil de commande (32), une section terminale (20) de la feuille flexible (10) étant placée en contact électrique (30) au niveau d'un point de contact (40) par application de chaleur (38), **caractérisée en ce que** la section terminale (20) de la feuille flexible (10) est réalisée au niveau du point de contact (40), au niveau des contacts électriques (26, 68) réalisés de façon saillante.

2. Mise en contact électrique selon la revendication 1, **caractérisée en ce que** les contacts électriques (26, 68) sont mis au contact d'un support de circuit (24) et ressortent dans un espace libre (48) d'un carter (22) ou saillent hors d'une baguette de contact (66).

3. Mise en contact électrique selon la revendication 1, **caractérisée en ce que** la section terminale (20) de la feuille flexible (10) prend la forme d'un battement de vagues, notamment d'une déviation (18).

4. Mise en contact électrique selon la revendication 3, **caractérisée en ce que** la déviation (18) est réalisée selon un angle compris entre 0° et 270°, notamment de 180°.

5. Mise en contact électrique selon la revendication 3, **caractérisée en ce que** la feuille flexible (10) comporte une ouverture (42) pratiquée dans une couche de revêtement (16) dans la région de la déviation (18) ou que la couche de revêtement est totalement ou partiellement supprimée dans la région de la déviation.

6. Mise en contact électrique (30) selon la revendication 1, **caractérisée en ce que** la feuille flexible (10) est maintenue le long de la déviation (18) par un noyau d'appui (34) et/ou par des segments de noyau d'appui (34).

7. Mise en contact électrique (30) selon la revendication 1, **caractérisée en ce que** les contacts électriques (26, 68) prennent la forme de fils ronds comportant des bouts ronds (56) ou de lames plates (58) contenant des tôles de contact.

8. Mise en contact électrique (30) selon l'une quelconque des revendications précédentes, **caractérisée en ce que** le plan (74) de la feuille flexible (10) comportant une structure en couche (12) est réduit d'un angle de délimitation β donné par rapport à un plan de contact (76).

9. Mise en contact électrique (30) selon la revendication précédente, **caractérisée en ce que** l'angle de délimitation β est compris entre 0° et 90°, de préférence entre 20° et 50°.

10. Mise en contact électrique selon l'une quelconque des revendications précédentes, **caractérisée en ce qu'**au moins une piste conductrice (14) de la feuille flexible (10) est pré-étamée ou pourvue d'un matériau pouvant fondre en surface à l'intérieur d'une zone de fusion (54).

11. Mise en contact électrique selon l'une quelconque des revendications précédentes, **caractérisée en ce que** le point de contact (40) entre le contact électrique (26) et la zone dégagée de la piste conductrice (14) de la feuille flexible (10) présentant la structure en couche (12) se place selon un angle α compris entre 0° et 180°, notamment dans une plage angulaire comprise entre 30° et 150°.

12. Mise en contact électrique selon l'une quelconque des revendications précédentes, **caractérisée en ce que** le contact électrique (26) transperce entièrement, au niveau du point de contact (40), une structure en couche (12) ininterrompue de la feuille flexible (10), deux couches de revêtement et une piste conductrice (14) recouverte de ces couches.

13. Mise en contact électrique selon l'une quelconque des revendications précédentes, **caractérisée en ce que** les ouvertures (42) sont accessibles à l'intérieur des pistes conductrices (14) de la feuille flexible (10), s'étendent sur la largeur totale de la feuille flexible (10) ou recouvrent des régions individuelles au-dessus des pistes conductrices (14), la largeur des ouvertures (42) étant supérieure, inférieure ou égale à la largeur des pistes conductrices (14).

14. Procédé de fabrication d'une mise en contact électrique (30) selon les étapes de procédé suivantes :
a) production d'une déviation (18) prévue au niveau d'une section terminale (20) d'une feuille (10) comportant une structure en couche (12) ;
b) dégagement d'au moins une piste conductrice (14) dans la feuille flexible (10) ;
c) introduction de la section terminale (20) ouverte comportant la déviation (18) de la feuille flexible (10) dans une région de mise en contact (48) ;
d) production d'une application de chaleur (38) orientée sur un point de contact (40) prévu entre au moins un contact électrique (26) et les régions dégagées des pistes conductrices (14) pour réaliser une liaison par complémentarité de matières servant de mise en contact électrique (30).

15. Procédé selon la revendication électrique, **caractérisé en ce que** l'application de chaleur (18) se produit au niveau du point de contact (40) par en haut, par en bas ou simultanément par en haut et par en bas.

16. Procédé selon l'une quelconque des revendications précédentes, **caractérisé en ce que** la mise en contact électrique (30) se produit au niveau d'un point de contact (40) placé, par rapport à la verticale, dans une section terminale, selon un angle a compris entre 0° et 180°, notamment entre 20° et 160°.
